# EUROPÄISCHE PATENTSCHRIFT

(11) **EP 3 199 978 B1**
(45) Veröffentlichungstag und Bekanntmachung des Hinweises auf die Patenterteilung: **07.08.2019**
(21) Anmeldenummer: 16204877.1
(22) Anmeldetag: 16.12.2016
(51) Int. Cl.: H03K 17/94, G01S 17/42, G01S 7/48, G01S 7/497

(54) **OPTOELEKTRONISCHER SENSOR**
OPTOELECTRONIC SENSOR
CAPTEUR OPTOÉLECTRONIQUE

(30) Priorität: 11.01.2016 DE 102016100322
(43) Veröffentlichungstag der Anmeldung: 02.08.2017
(73) Patentinhaber: SICK AG, 79183 Waldkirch/Breisgau (DE)
(72) Erfinder: Jachmann, Fabian, 79102 Freiburg (DE)
(74) Vertreter: Manitz Finsterwald Patent- und Rechtsanwaltspartnerschaft mbB

(56) Entgegenhaltungen:
- EP-A1- 2 237 065
- DE-A1- 3 408 261
- DE-A1- 10 151 979
- DE-A1- 10 340 702
- DE-C1- 19 732 776
- US-A1- 2008 158 555

## Beschreibung

Die vorliegende Erfindung betrifft einen optoelektronischen Sensor zur Überwachung eines Überwachungsbereichs, mit einem Hauptlichtsender zur Aussendung von Abtastlichtsignalen, welche durch eine Schutzscheibe hindurch in den Überwachungsbereich gelangen, einem Hauptlichtempfänger zum Empfangen von Licht, das aus dem Überwachungsbereich kommt, und einer Steuereinheit zur Steuerung des Sensors. Dabei ist der Sensor ausgebildet, eine Verschmutzungserkennung durchzuführen.

Ein optoelektronischer Sensor gemäß dem Oberbegriff des Anspruchs 1 ist aus der DE 101 51 979 A1 bekannt.

Zur Überwachung, beispielsweise von Arbeitsbereichen oder von Maschinen, werden häufig optoelektronische Sensoren, insbesondere in der Form von Laserscannern, eingesetzt. Ebenfalls können derartige optoelektronische Sensoren bzw. Scanner zur Absicherung von fahrerlosen Transportsystemen (sogenannten AGVs - Automated Guided Vehicle) verwendet werden, wobei der optoelektronische Sensor auf dem fahrerlosen Transportsystem montiert sein kann. Der optoelektronische Sensor dient dazu, Gegenstände, Personen und dergleichen in dem Überwachungsbereich zu erkennen und gegebenenfalls ein Warnsignal auszugeben, woraufhin das Transportsystem z.B. stoppt, um eine Kollision mit einer Person zu verhindern.

Hierzu kann der optoelektronische Sensor während der Überwachung Abtastlichtsignale in den Überwachungsbereich aussenden, welche von einem dort gegebenenfalls vorhandenen Objekt remittiert bzw. reflektiert werden. Zumindest ein Teil des remittierten bzw. reflektierten Lichts gelangt wieder zu dem optoelektronischen Sensor und wird dort von dem Hauptlichtempfänger detektiert.

Derartige optoelektronische Sensoren können nicht nur zur Überwachung eines Überwachungsbereichs bzw. eines Schutz- und/oder Gefahrenbereichs eingesetzt werden, sondern dienen auch zur Erstellung von Entfernungsprofilen und zur 3D-Abtastung. Der verwendete Begriff "Überwachung" soll in diesem allgemeinen Sinn verstanden werden, auch wenn hier mehrheitlich Beispiele der Sicherheitsanwendung beschrieben sind.

Bekannte optoelektronische Sensoren umfassen eine Steuereinheit, die die Funktionen des Sensors steuert und überwacht. Zur Veränderung der Funktion des Sensors sind üblicherweise Schalter oder eine Tastatur vorgesehen, mit der beispielsweise bestimmte Funktionen des Sensors aktiviert oder deaktiviert werden können.

Nachteiligerweise benötigen die Schalter oder die Tastatur einen gewissen Bauraum, wodurch die Sensoren vergrößert werden. Zudem verursachen sie als weitere Komponenten zusätzliche Herstellungs- und Wartungskosten.

Es ist deshalb die der Erfindung zugrundeliegende Aufgabe, einen optoelektronischen Sensor anzugeben, der auf einfache Weise manuell bedienbar ist, eine kompakte Bauform aufweist und mit geringen Kosten herstellbar ist.

Diese Aufgabe wird durch einen optoelektronischen Sensor gemäß Anspruch 1 und insbesondere dadurch gelöst, dass bei der Verschmutzungsmessung der Grad der Verschmutzung der Schutzscheibe mittels eines Verschmutzungsmesswerts ermittelt wird und dass die Steuereinheit eingerichtet ist, anhand der Verschmutzungserkennung das Annähern einer Hand und/oder eines Fingers an die Schutzscheibe zu erkennen und beim Erkennen der Hand und/oder des Fingers ein Aktionssignal auszugeben. Das Annähern der Hand oder des Fingers an die Schutzscheibe kann also das Drücken einer Taste oder das Betätigen eines Schalters ersetzen.

Die Erfindung macht sich hierbei die Erkenntnis zunutze, dass eine ohnehin in dem Sensor vorgesehene Verschmutzungserkennung auch zur Erkennung einer Hand oder eines Fingers herangezogen werden kann, um hierdurch Eingaben an dem Sensor vorzunehmen, die üblicherweise mittels der Schalter oder der Tastatur erfolgen. Auf diese Weise können die Schalter und/oder die Tastatur entfallen, wodurch der Sensor zugleich kompakter und mit geringeren Kosten herstellbar ist.

Ausgelöst durch das Aktionssignal können Aktionen durchgeführt werden, die beispielsweise eine Veränderung der Abtastrate oder der Reichweite des Sensors bewirken.

Beispielsweise kann zur Durchführung der Aktion eine Hand oder ein Finger auf die Schutzscheibe aufgelegt werden, wodurch die Hand oder der Finger als besonders starker "Schmutz" erkannt wird, wobei eine solch starke Verschmutzung (und damit ein besonders hoher Verschmutzungsmesswert) üblicherweise nicht vorkommt. Insofern kann eine Unterscheidung zwischen "normalem" Schmutz und der Hand bzw. dem Finger erfolgen. In Reaktion auf die aufgelegte Hand oder den Finger wird dann das Aktionssignal ausgegeben.

Grundsätzlich kann es sich bei dem Hauptlichtsender um einen Laser handeln, der die Abtastlichtsignale beispielsweise über einen sich drehenden Sensorkopf in den Überwachungsbereich abstrahlt. Der Sensor kann also ein Laserscanner sein. Die Schutzscheibe kann umlaufend um den Sensorkopf ausgebildet sein und dem Sensorkopf eine 360°-Sicht gestatten, wodurch sich der Überwachungsbereich allseitig des optoelektronischen Sensors befinden kann.

Anstelle einer Hand oder eines Finger kann auch ein anderes Körperteil oder ein anderer nicht transparenter Gegenstand verwendet werden, um das Aktionssignal auszulösen.

Vorteilhafte Weiterbildungen der Erfindung sind der Beschreibung, der Zeichnung sowie den Unteransprüchen zu entnehmen.

Erfindungsgemäß ist der Sensor ausgebildet, zur Durchführung der Verschmutzungserkennung ein Überwachungslichtsignal durch die Schutzscheibe hindurch zu emittieren, wobei der Sensor bevorzugt ausgebildet ist, eine Transmission durch die Schutzscheibe und/oder eine Reflexion an der Schutzscheibe zu messen. Mittels des Überwachungslichtsignals kann also z.B. die Transmission durch die Schutzscheibe gemessen werden, die bei steigender Verschmutzung der Schutzscheibe abnimmt. Beim Auflegen oder Annähern einer Hand oder eines Fingers an die Schutzscheibe kann die Transmission besonders stark sinken und insbesondere vollständig unterbunden werden.

Bei der Messung einer Reflexion an der Schutzscheibe kann die Reflexion dazu verwendet werden, Schmutz, eine Hand oder einen Finger zu erkennen (d.h. die Präsenz einer Hand oder eines Fingers wird erkannt), da sowohl Schmutz, als auch ein Finger oder eine Hand das Überwachungslichtsignal zumindest teilweise reflektieren können. Bei einer auftretenden sehr starken Reflexion an der Schutzscheibe kann dementsprechend davon ausgegangen werden, dass eine Hand oder ein Finger an der Schutzscheibe z.B. anliegt.

Bevorzugt ist der Hauptlichtsender zur Aussendung des Überwachungslichtsignals eingerichtet und/oder ist der Hauptlichtempfänger zum Empfang des Überwachungslichtsignals ausgebildet. Das Überwachungslichtsignal kann also mit dem Abtastlichtsignal identisch sein, wobei eine Reflexion an der Schutzscheibe auch über das Abtastlichtsignal messbar ist. Hierzu kann beispielsweise von dem empfangenen Licht, das eine Reflexion des Abtastlichtsignals ist, lediglich derjenige Signalanteil herangezogen werden, der aufgrund seiner Laufzeit als von der Schutzscheibe stammend identifiziert wird. Die Verschmutzungserkennung kann folglich eine Laufzeitmessung umfassen, um von der Schutzscheibe, von Schmutz, von einer Hand oder von einem Finger reflektierte Abtastlichtsignale zu erkennen.

Alternativ oder zusätzlich umfasst der Sensor zumindest einen Zusatzlichtsender, welcher zur Aussendung des Überwachungslichtsignals eingerichtet ist, und/oder umfasst der Sensor zumindest einen Zusatzlichtempfänger, der zum Empfang des Überwachungslichtsignals ausgebildet ist. Dies bedeutet, dass die Verschmutzungserkennung von einem von dem Hauptlichtsender und/oder dem Hauptlichtempfänger separaten System durchgeführt werden kann, nämlich von dem Zusatzlichtsender und/oder dem Zusatzlichtempfänger. Der Zusatzlichtsender ist bevorzugt getrennt von dem Hauptlichtsender angeordnet. Beispielsweise können auch mehrere Zusatzlichtsender und/oder mehrere Zusatzlichtempfänger vorgesehen sein, die bevorzugt jeweils eine Verschmutzungserkennung an unterschiedlichen Stellen der Schutzscheibe vornehmen.

Erfindungsgemäß umfasst die Schutzscheibe einen Eingriffsbereich, welcher für eine Hand und/oder einen Finger von außerhalb des Sensors zugänglich ist, wobei die Schutzscheibe und der Eingriffsbereich derart geformt sind, dass das Überwachungslichtsignal die Schutzscheibe an einer ersten Stelle durchdringt, den Eingriffsbereich durchläuft und anschließend die Schutzscheibe an einer zweiten Stelle durchdringt.

Die Schutzscheibe ist erfindungsgemäß im Eingriffsbereich konkav ausgebildet, so dass bei einer geradlinigen Ausbreitung des Überwachungslichtsignals das Überwachungslichtsignal den Eingriffsbereich durchlaufen kann. Wird nun eine Hand oder ein Finger in den Eingriffsbereich gehalten oder im Eingriffsbereich auf die Schutzscheibe aufgelegt, so kann das Überwachungslichtsignal am Durchlaufen des Eingriffsbereichs gehindert werden, wodurch das Überwachungslichtsignal die Schutzscheibe an der zweiten Stelle nicht mehr durchdringen kann. Eine solche Absorption des Überwachungslichtsignals kann z.B. durch den Zusatzlichtempfänger detektiert werden, wobei die Steuereinheit daraufhin ein Aktionssignal ausgeben kann.

Liegt lediglich eine "normale" Verschmutzung vor, so kann das Überwachungslichtsignal beim Durchdringen der Schutzscheibe von auf der Schutzscheibe befindlichem Schmutz abgeschwächt werden, kann den Eingriffsbereich aber durchlaufen und in abgeschwächter Stärke zu dem Zusatzlichtempfänger gelangen. Der Zusatzlichtempfänger kann derart angeordnet sein, dass er das Überwachungslichtsignal nach dem Durchdringen der Schutzscheibe an der zweiten Stelle empfängt.

Erfindungsgemäß umfasst die Schutzscheibe eine umlaufende Seitenwand, wobei der Eingriffsbereich einen umlaufenden Rücksprung der Seitenwand definiert. Beispielsweise kann die Schutzscheibe topf-, hut- oder zylinderförmig ausgebildet sein. Hierbei kann die Schutzscheibe durch den umlaufenden Rücksprung im Querschnitt eine bereichsweise Z-förmige Gestalt aufweisen.

Bevorzugt sind im Bereich der umlaufenden Seitenwand mehrere Zusatzlichtsender und mehrere Zusatzlichtempfänger angeordnet. Beispielsweise können bei einer topf-, hut- oder zylinderförmigen Schutzscheibe die Zusatzlichtsender gleichmäßig in Umfangsrichtung der Seitenwand verteilt sein. Auf diese Weise kann an der gesamten Seitenwand eine Verschmutzungserkennung durchgeführt werden. Jedem Zusatzlichtsender kann beispielsweise genau ein Zusatzlichtempfänger zugeordnet sein.

Erfindungsgemäß ist die Steuereinheit eingerichtet, eine Hand oder einen Finger als erkannt anzusehen, wenn der Verschmutzungsmesswert einen vorbestimmten Schwellenwert überschreitet. Da eine Hand oder ein Finger undurchdringlich für das Überwachungslichtsignal der Verschmutzungserkennung ist, wird der Verschmutzungsmesswert, der den Grad der Verschmutzung angibt, bei einer Hand oder einem Finger sehr hoch sein, obwohl tatsächlich keine Verschmutzung vorliegt. Ein solcher hoher Verschmutzungsmesswert ist bevorzugt durch "normale" Verschmutzung nicht zu erreichen. Die Verwendung des Schwellenwerts gestattet es damit, eine sichere Unterscheidung zwischen einer Hand oder einem Finger und in der Realität üblicherweise auftretenden Verschmutzungen vorzunehmen.

Gemäß einer weiteren vorteilhaften Ausführungsform ist der Sensor ausgebildet, das Annähern einer Hand und/oder eines Fingers nur in einem vorbestimmten Erkennungsbereich der Schutzscheibe zu ermitteln, wobei der Erkennungsbereich bevorzugt weniger als 50%, besonders bevorzugt weniger als 10%, der Fläche der Schutzscheibe einnimmt. Dies bedeutet, das Aktionssignal kann durch eine Hand oder einen Finger nur im Erkennungsbereich ausgelöst werden, d.h., wenn beispielsweise ein Finger die Schutzscheibe im Erkennungsbereich berührt. Auf diese Weise wird ein Schutz gegen fälschlich ausgelöste Aktionssignale geschaffen, da z.B. eine auftretende außergewöhnlich starke Verschmutzung außerhalb des Erkennungsbereichs nicht zu einem Aktionssignal führt. Der Erkennungsbereich kann dabei eine beliebige Form auf der Oberfläche der Schutzscheibe aufweisen oder ein beliebiger vorbestimmter Bereich der Schutzscheibe sein.

Bevorzugt ist der Erkennungsbereich in mehrere vorbestimmte, voneinander getrennte Teilbereiche gegliedert. Die Teilbereiche gestatten es insbesondere, die korrekte Erkennung zu verbessern, ob tatsächlich die Ausgabe eines Aktionssignals gewünscht ist. Dies kann beispielsweise durch die Verwendung mehrerer Teilbereiche erfolgen, wobei ausschließlich bei der Erkennung einer Hand oder eines Fingers in jedem Teilbereich ein Aktionssignal ausgegeben wird. Hierdurch kann es beispielsweise erforderlich sein, mit gespreizten Fingern sämtliche Teilbereiche abzudecken, um eine Aktion des Sensors auszulösen.

Besonders bevorzugt ist die Steuereinheit eingerichtet, in Abhängigkeit von dem Teilbereich oder den Teilbereichen, in welchem/welchen eine Hand und/oder ein Finger erkannt wird, verschiedene Aktionssignale auszugeben. Hierzu kann eine in einem Teilbereich erkannte Hand oder ein erkannter Finger als logische "1" für den Teilbereich gelten, wohingegen für einen Teilbereich ohne erkannte Hand oder ohne erkannten Finger eine logische "0" verwendet wird. Die so vorgegebenen logischen Zustandsgrößen der Teilbereiche können logisch verknüpft werden, um verschiedene Aktionen auszulösen. Beispielsweise kann beim Vorliegen einer "1" in allen Teilbereichen ein erstes Aktionssignal ausgegeben werden, wohingegen beim Vorliegen einer logischen "1" nur in genau einem Teilbereich ein zweites Aktionssignal ausgegeben werden kann, welches eine Aktion auslöst, die von einer Aktion verschieden ist, die durch das erste Aktionssignal initiiert wird.

Gemäß einer weiteren vorteilhaften Ausführungsform ist die Steuereinheit eingerichtet, in Abhängigkeit von einer zeitlichen Komponente der Erkennung einer Hand und/oder eines Fingers in dem Erkennungsbereich oder in zumindest einem der Teilbereiche, verschiedene Aktionssignale auszugeben. Dies bedeutet, dass ein Aktionssignal beispielsweise nur dann ausgegeben wird, wenn die Präsenz einer Hand innerhalb einer vorbestimmten Zeitspanne mehrmals hintereinander neu erkannt wird, wobei zwischen der jeweiligen Erkennung Zeitdauern liegen müssen, in denen keine Hand erkannt wird. Beispielsweise können unterschiedliche Aktionssignale ausgegeben werden, wenn die Hand drei Mal innerhalb der Zeitspanne oder zehn Mal innerhalb der Zeitspanne erkannt wird. Auch kann z.B. mit einem Finger über die Oberfläche der Schutzscheibe gewischt werden, um zeitlich nacheinander den Finger in verschiedenen Teilbereichen zu platzieren. Dies kann ebenfalls erkannt werden, um wiederum, z.B. abhängig von der Richtung der Wischbewegung, verschiedene Aktionssignale auszugeben. Grundsätzlich ist es möglich, mit den Teilbereichen eine Art Tastatur auf der Oberfläche der Schutzscheibe zu bilden.

Erfindungsgemäß ist vorgesehen, dass nur ein vorbestimmter Anstieg des Verschmutzungsmesswerts innerhalb eines ebenfalls vorbestimmten Zeitintervalls zu einem Aktionssignal führt. So kann beispielsweise nur ein Anstieg des Verschmutzungsmesswerts, der in weniger als einer Sekunde von unterhalb eines unteren vorbestimmten Schwellenwerts über den bereits erwähnten (oberen) Schwellenwert steigt, zu einem Aktionssignal führen. Auf diese Weise wird ausgeschlossen, dass sich allmählich ansammelnder Schmutz zu einem Aktionssignal führt.

Gemäß einer weiteren vorteilhaften Ausführungsform sind der Erkennungsbereich und/oder die Teilbereiche markiert, bevorzugt mit Markierungen auf der Schutzscheibe. Die Markierungen können die Positionierung der Hand oder des Fingers erleichtern und zudem angeben, welche Aktionen eine Berührung der Schutzscheibe in welchen Bereichen nach sich zieht. Die Markierungen können beispielsweise fest angebrachte Beschriftungen, Pfeile, Umrandungen und dergleichen sein. Die Markierungen können aber auch z.B. mit sichtbarem Licht auf die Schutzscheibe projiziert werden.

Bevorzugt ist der Sensor ausgebildet, in Reaktion auf das Aktionssignal einen Reset auszuführen und/oder eine Funkschnittstelle zu aktivieren oder zu deaktivieren. Bei der Funkschnittstelle kann es sich beispielsweise um eine WLAN- oder Bluetooth-Schnittstelle handeln, die üblicherweise abgeschaltet ist, um eine EMV-Belastung durch den Sensor gering zu halten. Durch eine Berührung der Schutzscheibe in dem Erkennungsbereich kann die Funkschnittstelle beispielsweise für einen vorbestimmten Zeitraum aktiviert werden, um eine weiterführende Konfiguration des Sensors zu ermöglichen.

Grundsätzlich können die auf das Aktionssignal hin ausgeführten Aktionen auf nicht sicherheitsrelevante Funktionen beschränkt sein.

Weiterer Gegenstand der Erfindung ist ein Verfahren gemäß Anspruch 5.

Für das erfindungsgemäße Verfahren gelten die zu dem erfindungsgemäßen optoelektronischen Sensor getroffenen Aussagen entsprechend, insbesondere hinsichtlich Vorteilen und bevorzugten Ausführungsformen.

Nachfolgend wird die Erfindung rein beispielhaft unter Bezugnahme auf die Zeichnung beschrieben. Es zeigt:

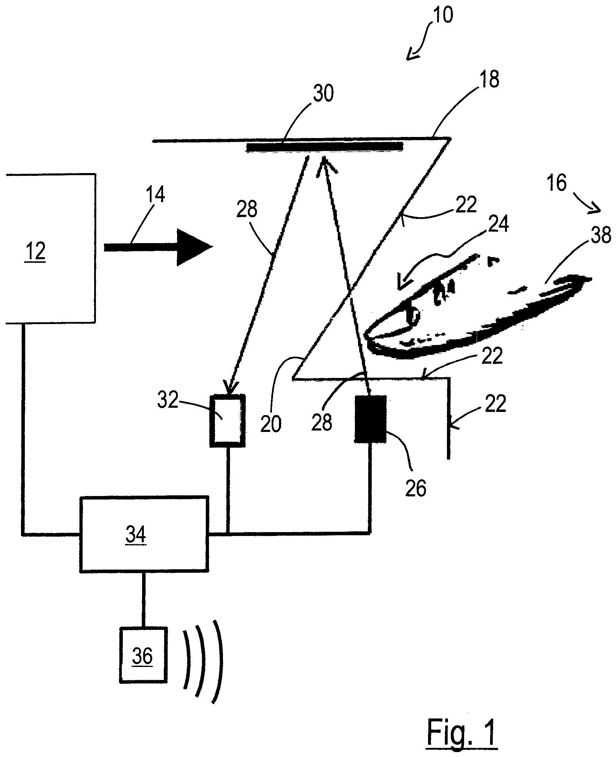

- Fig. 1: eine schematische Ansicht eines optoelektronischen Sensors.

Fig. 1 zeigt eine schematische Ansicht eines optoelektronischen Sensors, der als Laserscanner 10 ausgebildet ist. Der Laserscanner 10 umfasst einen rotierenden Sensorkopf 12, in dem eine Laserdiode als Hauptlichtsender und eine Fotodiodenzeile als Hauptlichtempfänger (beide nicht gezeigt) angeordnet sind. Von dem Sensorkopf 12 werden Abtastlichtsignale 14 in einen Überwachungsbereich 16 abgestrahlt.

Auf ihrem Weg in den Überwachungsbereich 16 durchtreten die Abtastlichtsignale 14 eine feststehende Schutzscheibe 18, die aus einem transparenten Material gefertigt ist. Die Schutzscheibe 18 ist bezüglich der (nicht gezeigten) Rotationsachse des Sensorkopfs 12 umlaufend um den Sensorkopf 12 ausgebildet und umfasst einen Rücksprung 20 in einer umlaufenden Seitenwand 22, welcher einen Eingriffsbereich 24 definiert.

Die Abtastlichtsignale 14 durchtreten die Schutzscheibe 18 im Bereich der umlaufenden Seitenwand 22.

Aufgrund des Rücksprungs 20 weist die Schutzscheibe 18 im Bereich der Seitenwand 22 eine im Querschnitt Z-förmige Gestalt auf.

Der Laserscanner 10 umfasst einen Zusatzlichtsender 26, der ein Überwachungslichtsignal 28 derart aussendet, dass es den Eingriffsbereich 24 durchläuft, wobei in Fig. 1 lediglich ein schematischer Strahlengang des Überwachungslichtsignals 28 dargestellt ist. Der Zusatzlichtsender 26 ist innerhalb der Schutzscheibe 18 angeordnet, so dass das Überwachungslichtsignal 28 vor und nach dem Durchlaufen des Eingriffsbereichs 24 die umlaufende Seitenwand 22 der Schutzscheibe 18 durchdringt. Nach dem zweiten Durchdringen der Seitenwand 22 trifft das Überwachungslichtsignal 28 auf einen Reflektor 30, der das Überwachungslichtsignal 28 einem Zusatzlichtempfänger 32 zuführt.

Der Zusatzlichtsender 26, der Zusatzlichtempfänger 32 und auch der Sensorkopf 12 sind mit einer Steuereinheit 34 gekoppelt. Die Steuereinheit 34 ist zudem mit einer WLAN-Schnittstelle 36 verbunden.

Beim Betrieb des Laserscanners 10 sendet der Sensorkopf 12 periodisch Abtastlichtsignale 14 in den Überwachungsbereich 16, um beispielsweise Gegenstände und Personen im Überwachungsbereich 16 zu detektieren.

Zugleich wird von dem Zusatzlichtsender 26 ein Überwachungslichtsignal 28 ausgesandt, das beim Durchdringen der Schutzscheibe 18 in Abhängigkeit des auf der Schutzscheibe 18 befindlichen Schmutzes abgeschwächt wird. Eine solche Abschwächung des Überwachungslichtsignals 28 kann von dem Zusatzlichtempfänger 32 detektiert werden.

Wird nun ein Finger 38 in den Eingriffsbereich 24 gebracht, so wird das Überwachungslichtsignal 28 nahezu vollständig unterbrochen, so dass fast kein Licht des Überwachungslichtsignals 28 zu dem Zusatzlichtempfänger 32 gelangt. Die Steuereinheit 34 erkennt dies wie eine sehr starke Verschmutzung bzw. als sehr hohen Verschmutzungsmesswert. Dabei wird ein Schwellenwert des Verschmutzungsmesswerts überschritten, wobei die Steuereinheit 34 bei der Überschreitung des Schwellenwerts vom Vorhandensein des Fingers 38 in dem Eingriffsbereich 24 ausgeht. Daraufhin gibt die Steuereinheit 34 ein Aktionssignal aus, das zur zeitweiligen Aktivierung der WLAN-Schnittstelle 36 führt.

Allein durch das Einbringen des Fingers 38 in den Eingriffsbereich 24 kann der Laserscanner 10 also auf einfache Weise in einen Modus geschaltet werden, in welchem der Laserscanner 10 über die WLAN-Schnittstelle 36 per Funk erreichbar ist.

### Bezugszeichenliste

- 10: Laserscanner
- 12: Sensorkopf
- 14: Abtastlichtsignal
- 16: Überwachungsbereich
- 18: Schutzscheibe
- 20: Rücksprung
- 22: umlaufende Seitenwand
- 24: Eingriffsbereich
- 26: Zusatzlichtsender
- 28: Überwachungslichtsignal
- 30: Reflektor
- 32: Zusatzlichtempfänger
- 34: Steuereinheit
- 36: WLAN-Schnittstelle
- 38: Finger

## Patentansprüche

1. Laserscanner (10) zur Überwachung eines Überwachungsbereichs (16), mit einem Hauptlichtsender zur Aussendung von Abtastlichtsignalen (14), welche durch eine Schutzscheibe (18) hindurch in den Überwachungsbereich (16) gelangen, einem Hauptlichtempfänger zum Empfangen von Licht, das aus dem Überwachungsbereich (16) kommt, und einer Steuereinheit (34) zur Steuerung des Laserscanners (10), wobei
der Laserscanner (10) ausgebildet ist, eine Verschmutzungserkennung durchzuführen, wobei
der Laserscanner (10) ausgebildet ist, zur Durchführung der Verschmutzungserkennung ein Überwachungslichtsignal (28) durch die Schutzscheibe (18) hindurch zu emittieren, und wobei
die Schutzscheibe (18) eine umlaufende Seitenwand (22) umfasst,
**dadurch gekennzeichnet, dass**
bei der Verschmutzungserkennung der Grad der Verschmutzung der Schutzscheibe (18) mittels eines Verschmutzungsmesswerts ermittelt wird, und die Steuereinheit (34) eingerichtet ist, anhand der Verschmutzungserkennung das Annähern einer Hand und/oder eines Fingers (38) an die Schutzscheibe (18) zu erkennen und beim Erkennen der Hand und/oder des Fingers (38) ein Aktionssignal auszugeben, wobei
die Steuereinheit (34) eingerichtet ist, eine Hand oder einen Finger (38) als erkannt anzusehen, wenn der Verschmutzungsmesswert einen vorbestimmten Schwellenwert überschreitet, und
wobei die Schutzscheibe (18) einen Eingriffsbereich (24) umfasst, welcher für eine Hand und/oder einen Finger (38) von außerhalb des Laserscanners (10) zugänglich ist, wobei die Schutzscheibe im Eingriffsbereich (24) konkav ausgebildet ist, wobei die Schutzscheibe (18) und der Eingriffsbereich (24) derart geformt sind, dass das Überwachungslichtsignal (28) die Schutzscheibe (18) an einer ersten Stelle durchdringt, den Eingriffsbereich (24) durchläuft und anschließend die Schutzscheibe (18) an einer zweiten Stelle durchdringt, wobei der Eingriffsbereich (24) einen umlaufenden Rücksprung (20) der Seitenwand (22) definiert,
wobei nur ein vorbestimmter Anstieg des Verschmutzungsmesswerts innerhalb eines ebenfalls vorbestimmten Zeitintervalls zu einem Aktionssignal führt.

2. Laserscanner (10) nach Anspruch 1,
**dadurch gekennzeichnet, dass**
der Laserscanner (10) ausgebildet ist, eine Transmission durch die Schutzscheibe (18) und/oder eine Reflexion an der Schutzscheibe (18) zu messen.

3. Laserscanner (10) nach Anspruch 2,
**dadurch gekennzeichnet, dass**
der Hauptlichtsender zur Aussendung des Überwachungslichtsignals (28) eingerichtet ist und/oder der Hauptlichtempfänger zum Empfang des Überwachungslichtsignals (28) ausgebildet ist.

4. Laserscanner (10) nach zumindest einem der vorstehenden Ansprüche,
**dadurch gekennzeichnet, dass**
der Laserscanner (10) ausgebildet ist, in Reaktion auf das Aktionssignal einen Reset auszuführen und/oder eine Funkschnittstelle zu aktivieren oder zu deaktivieren.

5. Verfahren zur Bedienung eines Laserscanners (10), der zur Überwachung eines Überwachungsbereichs (16) dient, wobei
der Laserscanner (10) mittels eines Hauptlichtsenders Abtastlichtsignale (14) durch eine Schutzscheibe (18) hindurch in den Überwachungsbereich (16) aussendet,
die Schutzscheibe (18) eine umlaufende Seitenwand (22) umfasst,
der Hauptlichtempfänger aus dem Überwachungsbereich (16) kommendes Licht empfängt, wobei
eine Verschmutzungserkennung durchgeführt wird,
und wobei, zur Durchführung der Verschmutzungserkennung ein Überwachungslichtsignal (28) durch die Schutzscheibe (18) hindurch emittiert wird,
**dadurch gekennzeichnet, dass**
bei der Verschmutzungserkennung der Grad der Verschmutzung der Schutzscheibe (18) mittels eines Verschmutzungsmesswerts ermittelt wird, und anhand der Verschmutzungserkennung das Annähern einer Hand und/oder eines Fingers (38) an die Schutzscheibe (18) erkannt wird und beim Erkennen der Hand und/oder des Fingers (38) ein Aktionssignal ausgegeben wird, wobei
eine Hand oder ein Finger (38) als erkannt angesehen werden, wenn der Verschmutzungsmesswert einen vorbestimmten Schwellenwert überschreitet, und
wobei die Schutzscheibe (18) einen Eingriffsbereich (24) umfasst, welcher für eine Hand und/oder einen Finger (38) von außerhalb des Laserscanners (10) zugänglich ist, wobei die Schutzscheibe im Eingriffsbereich (24) konkav ausgebildet ist, wobei die Schutzscheibe (18) und der Eingriffsbereich (24) derart geformt sind, dass das Überwachungslichtsignal (28) die Schutzscheibe (18) an einer ersten Stelle durchdringt, den Eingriffsbereich (24) durchläuft und anschließend die Schutzscheibe (18) an einer zweiten Stelle durchdringt, wobei der Eingriffsbereich (24) einen umlaufenden Rücksprung (20) der Seitenwand (22) definiert,
wobei nur ein vorbestimmter Anstieg des Verschmutzungsmesswerts innerhalb eines ebenfalls vorbestimmten Zeitintervalls zu einem Aktionssignal führt.

## Claims

1. A laser scanner (10) for monitoring a monitored zone (16), having a main light transmitter for transmitting sensing light signals (14) which propagate through a protective screen (18) into the monitored zone (16); having a main light receiver for receiving light which emanates from the monitored zone (16); and having a control unit (34) for controlling the laser scanner (10), wherein
the laser scanner (10) is configured to carry out a contamination recognition; wherein
the laser scanner (10) is configured to emit a monitoring light signal (28) through the protective screen (18) for carrying out the contamination recognition; and wherein
the protective screen (18) comprises a peripheral side wall (22), **characterized in that**
in the contamination recognition, the degree of contamination of the protective screen (18) is determined by means of a measured contamination value and the control unit (34) is adapted to recognize an approach of a hand and/or of a finger (38) toward the protective screen (18) based on the contamination recognition and to output an action signal on the recognition of the hand and/or of the finger (38), with the control unit (34) being adapted to consider a hand or a finger (38) as recognized when the measured contamination value exceeds a predefined threshold value, and
with the protective screen (18) comprising an engagement region (24) which is accessible for a hand and/or for a finger (38) from outside the laser scanner (10), with the protective screen being concave in the engagement region (24), with the protective screen (18) and the engagement region (24) being shaped such that the monitoring light signal (28) passes through the protective screen (18) at a first point, runs through the engagement region (24) and subsequently passes through the protective screen (18) at a second point, with the engagement region (24) defining a peripheral recess (20) of the side wall (22), and
with only a predefined increase in the measured contamination value within a likewise predefined time interval resulting in an action signal.

2. A laser scanner (10) in accordance with claim 1,
**characterized in that**
the laser scanner (10) is configured to measure a transmission through the protective screen (18) and/or a reflection at the protective screen (18).

3. A laser scanner (10) in accordance with claim 2,
**characterized in that**
the main light transmitter is configured to transmit the monitoring light signal (28) and/or the main light receiver is configured to receive the monitoring light signal (28).

4. A laser scanner (10) in accordance with at least one of the preceding claims,
**characterized in that**
the laser scanner (10) is configured to carry out a reset in response to the action signal and/or to activate or deactivate a radio interface.

5. A method of operating a laser scanner (10) which serves for the monitoring of a monitored zone (16), wherein
the laser scanner (10) transmits sensing light signals (14) through a protective screen (18) into the monitored zone (16) by means of a main light transmitter,
the protective screen (18) comprises a peripheral side wall (22), and
the main light receiver receives light emanating from the monitored zone (16); wherein
a contamination recognition is carried out;
and wherein a monitoring light signal (28) is emitted through the protective screen (18) for carrying out the contamination recognition,
**characterized in that**
in the contamination recognition, the degree of contamination of the protective screen (18) is determined by means of a measured contamination value and the approach of a hand and/or of a finger (38) toward the protective screen (18) is recognized based on the contamination recognition and an action signal is output on the recognition of the hand and/or of the finger (38), with
a hand or a finger (38) being considered as recognized when the measured contamination value exceeds a predefined threshold value, and
with the protective screen (18) comprising an engagement region (24) which is accessible for a hand and/or for a finger (38) from outside the laser scanner (10), with the protective screen being concave in the engagement region (24), with the protective screen (18) and the engagement region (24) being shaped such that the monitoring light signal (28) passes through the protective screen (18) at a first point, runs through the engagement region (24) and subsequently passes through the protective screen (18) at a second point, with the engagement region (24) defining a peripheral recess (20) of the side wall (22), and
with only a predefined increase in the measured contamination value within a likewise predefined time interval resulting in an action signal.

## Revendications

1. Scanneur laser (10) pour la surveillance d'une zone à surveiller (16), comportant
un émetteur de lumière principal pour émettre des signaux lumineux de balayage (14) qui parviennent dans la zone à surveiller (16) à travers une vitre de protection (18),
un récepteur de lumière principal pour recevoir la lumière en provenance de la zone à surveiller (16), et
une unité de commande (34) pour commander le scanneur laser (10), dans lequel
le scanneur laser (10) est réalisé pour effectuer une reconnaissance d'encrassement,
le scanneur laser (10) est réalisé pour émettre un signal lumineux de surveillance (28) à travers la vitre de protection (18), afin d'effectuer la reconnaissance d'encrassement, et
la vitre de protection (18) comprend une paroi latérale périphérique (22), **caractérisé en ce que**
lors de la reconnaissance d'encrassement, le degré de l'encrassement de la vitre de protection (18) est déterminé à l'aide d'une valeur mesurée d'encrassement, et
l'unité de commande (34) est conçue pour reconnaître l'approche d'une main et/ou d'un doigt (38) vers la vitre de protection (18) en se basant sur la reconnaissance d'encrassement et pour émettre un signal d'action lorsque la main et/ou le doigt (38) est reconnu(e),
l'unité de commande (34) est conçue pour considérer une main ou un doigt (38) comme reconnu(e) si la valeur mesurée d'encrassement dépasse une valeur seuil prédéterminée, et
la vitre de protection (18) comprend une zone d'engagement (24) accessible à une main et/ou à un doigt (38) depuis l'extérieur du scanneur laser (10),
la vitre de protection est réalisée concave dans la zone d'engagement (24), la vitre de protection (18) et la zone d'engagement (24) sont formées de telle sorte que le signal lumineux de surveillance (28) pénètre la vitre de protection (18) à un premier emplacement, traverse la zone d'engagement (24) et pénètre ensuite la vitre de protection (18) à un second emplacement,
la zone d'engagement (24) définit un retrait périphérique (20) de la paroi latérale (22),
seule une augmentation prédéterminée de la valeur mesurée d'encrassement à l'intérieur d'un intervalle de temps également prédéterminé aboutit à un signal d'action.

2. Scanneur laser (10) selon la revendication 1,
**caractérisé en ce que**
le scanneur laser (10) est réalisé pour mesurer une transmission à travers la vitre de protection (18) et/ou une réflexion sur la vitre de protection (18).

3. Scanneur laser (10) selon la revendication 2,
**caractérisé en ce que**
l'émetteur de lumière principal est conçu pour émettre le signal lumineux de surveillance (28) et/ou le récepteur de lumière principal est réalisé pour recevoir le signal lumineux de surveillance (28).

4. Scanneur laser (10) selon l'une au moins des revendications précédentes,
**caractérisé en ce que**
le scanneur laser (10) est réalisé pour effectuer une remise à zéro et/ou pour activer ou désactiver une interface radio, en réponse au signal d'action.

5. Procédé de manipulation d'un scanneur laser (10) qui sert à la surveillance d'une zone à surveiller (16),
dans lequel
le scanneur laser (10) émet des signaux lumineux de balayage (14) à travers une vitre de protection (18) jusque dans la zone à surveiller (16) à l'aide d'un émetteur de lumière principal,
la vitre de protection (18) comprend une paroi latérale périphérique (22),
le récepteur de lumière principal reçoit la lumière en provenance de la zone à surveiller (16),
une reconnaissance d'encrassement est effectuée, et
pour effectuer la reconnaissance d'encrassement, un signal lumineux de surveillance (28) est émis à travers la vitre de protection (18),
**caractérisé en ce que**
lors de la reconnaissance d'encrassement, le degré de l'encrassement de la vitre de protection (18) est déterminé à l'aide d'une valeur mesurée d'encrassement, et
l'approche d'une main et/ou d'un doigt (38) vers la vitre de protection (18) est reconnue sur la base de la reconnaissance d'encrassement, et
un signal d'action est émis lorsque la main et/ou le doigt (38) est reconnu(e),
une main ou un doigt (38) est considéré(e) comme reconnu(e) si la valeur mesurée d'encrassement dépasse une valeur seuil prédéterminée, et
la vitre de protection (18) comprend une zone d'engagement (24) accessible à une main et/ou à un doigt (38) depuis l'extérieur du scanneur laser (10),
la vitre de protection est réalisée concave dans la zone d'engagement (24),
la vitre de protection (18) et la zone d'engagement (24) sont formées de telle sorte que le signal lumineux de surveillance (28) pénètre la vitre de protection (18) à un premier emplacement, traverse la zone d'engagement (24) et pénètre ensuite la vitre de protection (18) à un second emplacement,
la zone d'engagement (24) définit un retrait périphérique (20) de la paroi latérale (22),
seule une augmentation prédéterminée de la valeur mesurée d'encrassement à l'intérieur d'un intervalle de temps également prédéterminé aboutit à un signal d'action.
